# EUROPEAN PATENT SPECIFICATION

(11) **EP 2 561 620 B1**
(45) Date of publication and mention of the grant of the patent: **17.12.2014**
(21) Application number: 11718475.4
(22) Date of filing: 11.04.2011
(51) Int. Cl.: H04B 1/40, H04B 5/00, H04N 5/44, G08C 17/02

(54) **WIRELESS CONTROL DEVICE**
DRAHTLOSE STEUERVORRICHTUNG
DISPOSITIF DE COMMANDE SANS FIL

(30) Priority: 19.04.2010 GB 201006459
(43) Date of publication of application: 27.02.2013
(73) Proprietor: Siemens Aktiengesellschaft, 80333 München (DE)
(72) Inventor: BEASLEY, Paul, Abingdon Oxfordshire OX14 3XP (GB); HEID, Oliver, 91052 Erlangen (DE)
(74) Representative: Maier, Daniel Oliver
(86) International application number: PCT/GB2011/050712
(87) International publication number: WO 2011/131962

(56) References cited:
- WO-A1-00/67373
- WO-A1-2008/068078
- GB-A- 2 337 422
- GB-A- 2 344 021
- US-A1- 2007 207 763
- US-A1- 2008 225 932

## Description

This invention relates to a wireless control device, in particular for consumer electronics, such as personal computers or entertainment devices.

Conventionally, all remote control devices require a power source of their own, typically batteries. However, as well as the nuisance to the user when the battery runs out, there are environmental issues with the large number of batteries which must be safely disposed of and the consequent expense, both to user and manufacturer.

Many proposals have been made to reduce the power consumption of such devices, in order that the batteries need to be replaced less frequently, but this only reduces the problem, rather than avoiding it. An example of this is US6507763 which mentions using a radio frequency wireless keyboard in place of an infrared one because the RF keyboard uses less power. It does not address the nuisance to the user of having to keep many different sizes of spare batteries for different devices, in case they run out when it is not convenient to go out an purchase new ones.

Another feature of such remote control devices is that they must transmit data to the computer or entertainment device, without being physically connected. An example of this is described in US5365230 which uses scan codes encoded in a variable magnetic field to enable the computer to determine which keys the user has pressed. However, this keyboard still requires a separate power supply within the keyboard, with its attendant problems. Furthermore, the input signal may be relatively weak, so limiting the distance over which the remote control device can work.

US2006/0281435 describes a power harvesting method to power or augment an existing power supply on an untethered device including an integrated circuit, such as an RFID sensor for an alarm by harvesting ambient or directed RF energy by rectifying received AC to DC.

US2008/225932A1 describes a data transmission device for sending back data on a reflected wave of an unmodulated carrier.

In accordance with a first aspect of the present invention, a wireless control device comprises an antenna and a power harvester to generate power for the device from a radio frequency signal incident on the antenna; the device further comprising an upconverter stage; the upconverter stage comprising one of a low noise amplifier and a two port mixer, or a two port parametric amplifier; the two ports comprisng a first port to receive a control signal to be upconverted and a second port to receive the incident radio frequency signal and to output the upconverted control signal at upper and lower sideband frequencies; wherein the antenna is coupled to the second port.

The present invention provides a wireless control device which is able to harvest an incident radio frequency signal to power the device, whilst also using that signal to upconvert a signal for transmission.

Preferably, when the upconverter stage comprises a two port parametric amplifier, a low noise amplifier is provided at the first port of the parametric amplifier.

Preferably, when the upconverter stage comprises a two port parametric amplifier, the two port parametric amplifier comprises a pair of varactor diodes connected between the first port and the second port; wherein the diodes are connected in parallel from the first port and in series from the second port; wherein the first port receives an input signal via the low noise amplifier; and wherein the second port receives an incident local oscillator signal and outputs an upconverted amplified input signal.

Preferably, the power harvester provides a DC voltage supply to the low noise amplifier.

Preferably, the power harvester includes a Cockcroft Walton multiplier.

Preferably, the power harvester includes an impedance circuit to increase the available RF voltage from the local oscillator prior to rectification to DC.

Preferably, when the upconverter stage comprises a low noise amplifier (20) and a two port mixer (23), the upconverter further comprises a power splitter coupled between the second port of the mixer and the antenna.

Preferably, the power splitter splits incident local oscillator power between two outputs, one output being connected to the power harvester and the other output being connected to the second port of the upconverter stage.

Preferably, the power splitter comprises one of a directional coupler and a Wilkinson coupler.

Preferably, the second port receives signals in the frequency range 2GHz to 3 GHz.

Preferably, the wireless control device is one of a games console remote control, a personal entertainment remote control, a keyboard, or a mouse.

In accordance with a second aspect of the present invention, a wireless system comprises a device according to the first aspect and a host, the host further comprising a signal generator to generate the radio frequency signal and an antenna from which to transmit the radio frequency signal.

An example of a wireless control device according to the present invention will now be described with reference to the accompanying drawings in which:
Figure 1 illustrates examples of wireless control devices according to the present invention;
Figure 2 illustrates in more detail, an example of an upconverter for use in a wireless control device according to the present invention;
Figure 3 illustrates the mixer in the upconverter of Fig.2 in more detail;
Figure 4 illustrates power harvesting with the upconverter of Fig. 2, for use in the wireless control device of Fig.1;
Figure 5a illustrates a symmetric power splitter;
Figure 5b illustrates an asymmetric power splitter;
Figure 6a illustrates a quadrature hybrid branch line splitter;
Figure 6b illustrates an edge coupler;
Figure 7 illustrates a simple rectifier circuit for use as a power harvester in the device of Fig.4;
Figure 8 shows an alternative example of a rectifier circuit for use as a power harvester in the device of Fig.4;
Figure 9 illustrates an alternative embodiment of an upconverter for use in a wireless control device according to the present invention, using a two port parametric amplifier;
Figure 10 is a block diagram of the upconverter of Fig.9, incorporating power harvesting; and,
Figure 11 is a block diagram of a modified upconverter according to Fig.10.

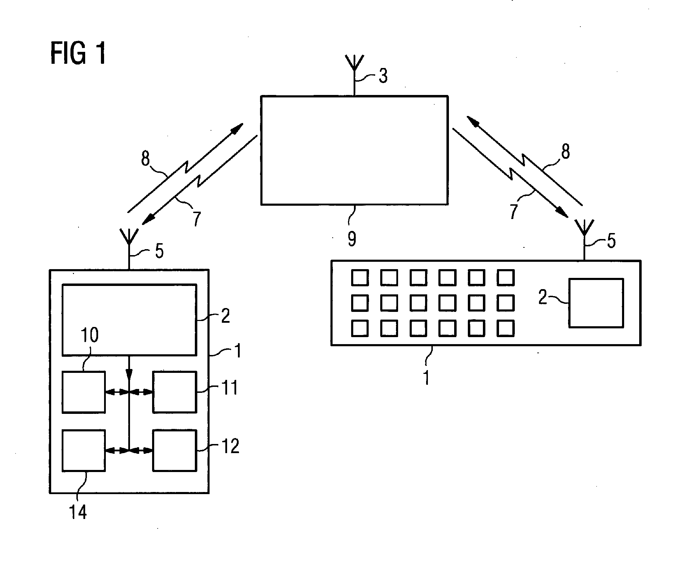

Various embodiments of the present invention are possible and examples of a number of these will be described hereinafter. Fig. 1 illustrates the basic arrangement of the present invention, in which a wireless control device 1, such as a computer keyboard, computer mouse, television remote control, or wireless games controller, is provided with a power harvesting circuit 2 in order to generate power for the wireless control device. The power harvesting circuit 2 converts energy in a radio frequency (RF) signal 7 received at an antenna 5 on the device 1 into a source of power for the control device. The RF signal 7 is typically one that has been transmitted from an antenna 3 on a host 9, such as a personal computer in the case of a keyboard or mouse, or a television set for the television remote control, although a single transmitter incorporated into, or separate from the host, could be used to cover devices within a certain range, e.g. within a study or office, or a household. For convenience, the transmitted signal is generally a microwave signal with a typical frequency in the range of 2GHz to 3GHz, and will be referred to as such in this example. The power may be used to power the control device directly, for example to power a processor 10, display 11 or loudspeakers 12, or the harvested power may be stored in a store 14 within the wireless control device for later use. Furthermore, this same external source of energy is able to be used as a local oscillator 7 in order to upconvert a signal for transmission to the host and upper and lower sidebands of that signal are transmitted to the host using the same antenna 5 as that on which the incident radio frequency signal was received.

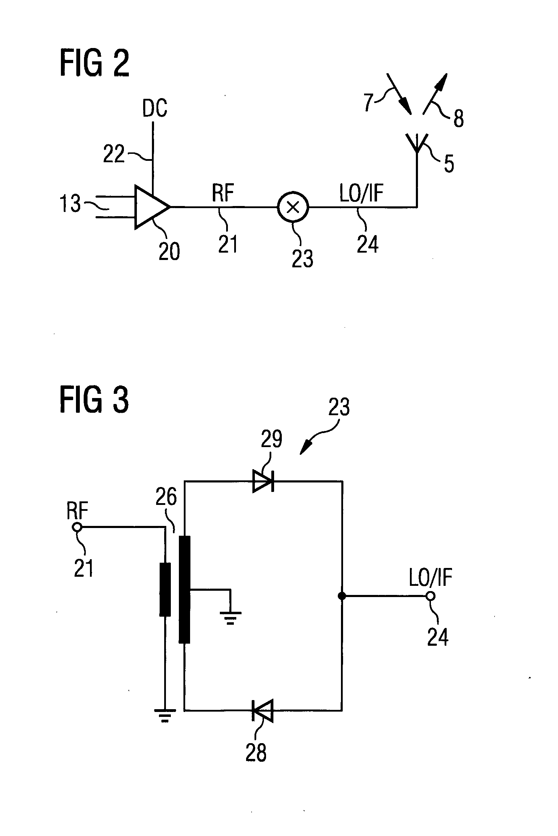

A first configuration of an upconverter which may be used in a wireless control device according to the invention is shown in Fig.2. A signal 13 for transmission to the host 9 is input to a low noise amplifier 20. The signal 13 is generated within the control device, for example by pressing a key, or by button click or press. The frequency of the signal so generated is not significant, as long as each command (press or click etc) is distinct. Following this each command can be given a signature for transmission. If necessary, the generated signal is converted to an optimum frequency for mixing. Typically, for a 2.5GHz link, the signal needs to be more than 20% away from the link frequency, so less than 250MHz. Nevertheless, the technique allows the use of a broad range of potential sub-carrier frequencies, with capacity for high data bandwidths. The quantity, speed and timing of the data transmission may be optimised to reduce cost and complexity of the parametric amplifier A DC voltage 22 powers the low noise amplifier. The DC supply to power the amplifier is provided by means of a power harvester as described below, directly or from the store 14, which may be, for example, a super capacitor that is charged at regular intervals. The input signal 13 is amplified in the amplifier 20 and the amplified signal is passed to a first port 21 of a two port mixer 23. The radio frequency signal 7 from the host antenna 3, which acts as both a source of energy and a local oscillator (LO) signal, is received at the antenna 5 connected to a second LO/IF intermediate frequency port 24 of the mixer. The input signal 13 and LO signal 7 are mixed in the mixer 23 to produce upper and lower sidebands and provide further amplification as necessary, so that the input signal 13 is upconverted. The upconverted signal including the sidebands is still within the bandwidth of the antenna 3 and one, other, or both of the sidebands 8 are radiated by the antenna 5 for reception by receivers in the host 9.

An example of an implementation of a two port mixer 23 is shown in Fig.3. A transformer 26 and diodes 28, 29 form the two port mixer 23. The arrangement of the diodes determines the direction of the current flow for the input LO signal 7 and output IF 8 respectively. The transformer may be implemented with trifilar wire in a resonant circuit. The output of the low noise amplifier 20 is connected to the input port 21 of the two port mixer 23 and an amplified input signal 13 is upconverted by the two port mixer 23, then connected to the antenna 5 for transmission of the upconverted signal sidebands 8.

As mentioned above, in order that the amplifier 20 is fully powered by the incident local oscillator signal, so that no external DC power source is required, power harvested from the local oscillator 7 is used. Thus, the antenna 5 of the upconverter stage provides LO power which is rectified to produce the DC voltage 22 to power the LNA 20. Furthermore, this power harvesting may be used in combination with a power splitter 44. In one example, the input of the power harvester may connect to a two way splitter, which may have symmetry or asymmetry of power splitter powers. The splitter may take the form of a Wilkinson splitter, or directional coupler, to provide isolation between the two split parts of the LO signal.

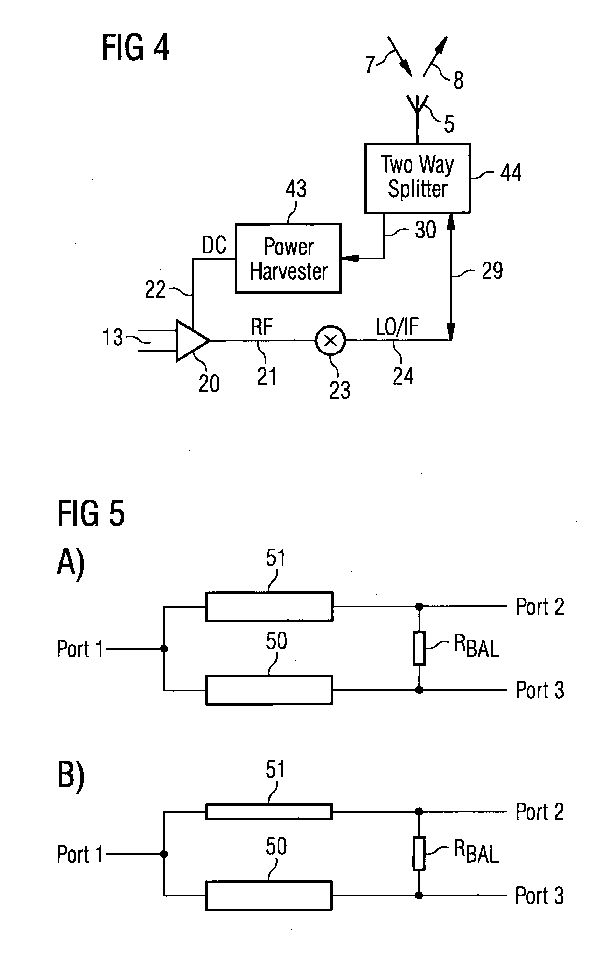

A suitable circuit to achieve this is illustrated in Fig. 4. A feed 29 from the antenna 5 is connected to the mixer LO/IF port 24 via a two way splitter 44 that may be implemented, for example, either as a Wilkinson coupler or as a directional coupler as known to those versed in the art. The coupler 44 provides isolation of the path 29 between the antenna 5 and the LO/IF port 24 from a second path 30 that connects to a power harvester 43 containing a rectifier to provide the DC 22 suitable for powering the amplifier 20. In this way, the upconverter circuit is completely powered by the local oscillator power that is incident on the microwave antenna 5. The present invention harvests some DC power from the local oscillator 7 to provide the necessary power for the amplifier. The power harvester 43 typically takes the form of a rectifier and a reservoir circuit, e.g. a capacitor, described in more detail hereinafter, arranged to obtain DC voltage, the circuit having a suitable voltage and current capability to power the low noise amplifier.

Different types of power splitter 44 may be used. In Fig. 5 are shown simplified forms, illustrating the operation of the power splitter. Fig. 5a illustrates a Wilkinson splitter. P1 sees an impedance of 50Ω. The signal splits equally through quarter wavelength lines 50, 51 at an impedance of approximately 72Ω. A balancing resistor at 100Ω is connected between P2 and P3. This arrangement gives a perfect match P1, if and only if, P2 and P3 are terminated in 50Ω. The arrangement presents a perfect match at P2 and P3, if and only if, P1 is terminated. The power incident on P1 is divided to give -3dB at P2 and P3. Fig.4 illustrates a pair of asymmetric Wilkinson splitters, each having two ¼ wavelength tracks of different width. Port P1 is equivalent to the input from the antenna 5 and ports P2 and P3 are connections to the mixer 23 and rectifier 43 respectively. In general, power is split equally between P2 and P3, but if there is a requirement for an asymmetric structure, giving rise to only a small part of the power going to the power harvester 43 and most of the power going to the mixer 23, then the arrangement shown in Fig. 5b may be used.

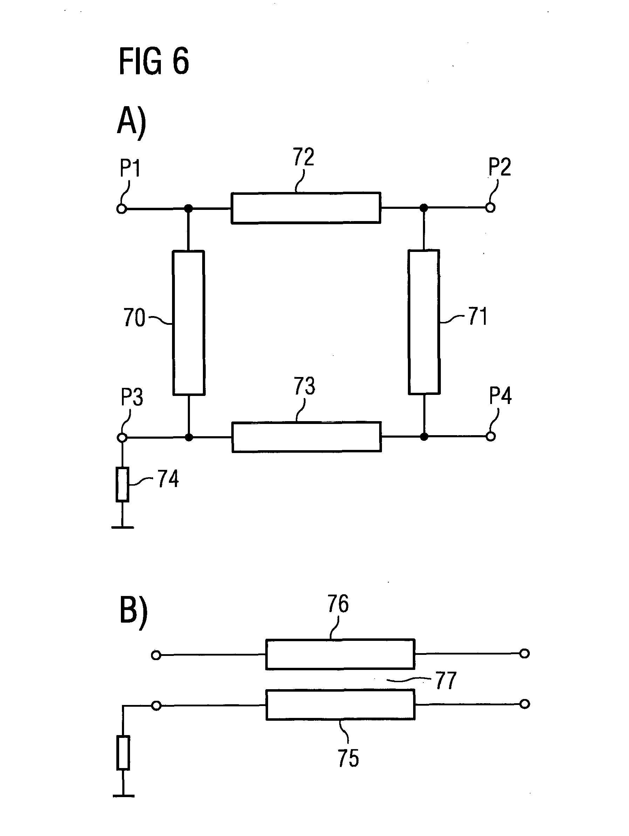

Other types of splitter include directional couplers, for example, either branch line or edge couplers. The branch line coupler of Fig.6a is a quadrature hybrid, where pairs 70, 71; 72, 73 of the same impedance are arranged to get power in at P1, dividing between P2 and P4, but with nothing out at P3, which is connected to ground. These are more difficult to manufacture than Wilkinson coupler's and as P3 is surplus to requirements, the couplers are also less compact. The edge coupler of Fig.6b is made by printing two tracks 75, 76 very close together. This has 4 ports and one is connected to earth via a dump resistor. The required gap 77 between the tracks would be too small for existing manufacturing tolerances, as the ratio of track width to thickness of the dielectric determines the necessary spacing.

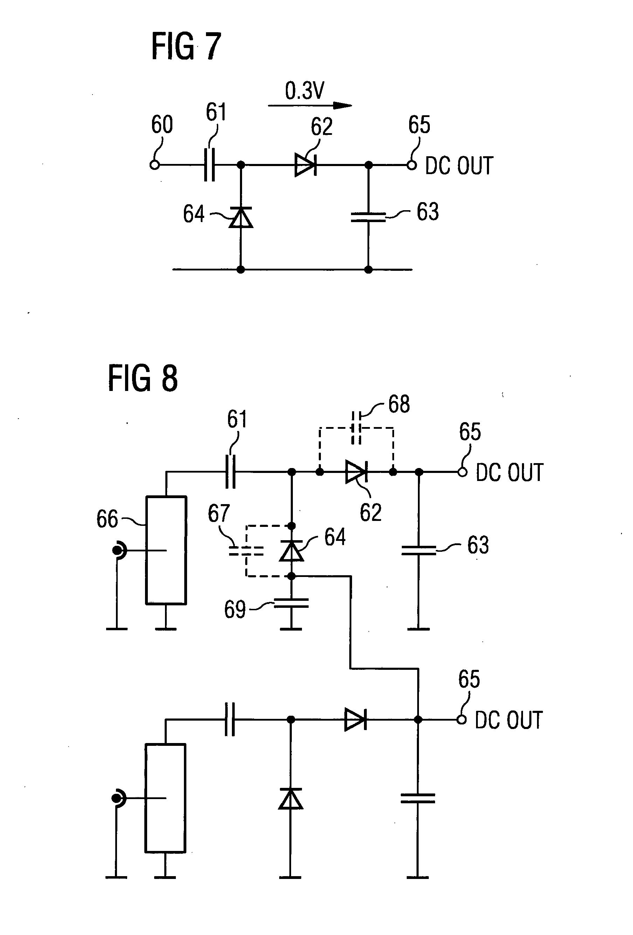

The power harvester 43 may incorporate a resonant voltage transformation circuit and/or a Cockcroft-Walton voltage multiplier as necessary to obtain the required output voltage. Fig.7 illustrates operation of an embodiment of a power harvester circuit suitable for the upconverter in the remote control device of the present invention. An input signal 60 sees a low impedance at RF frequency (e.g. 2.4GHz) in capacitor 61, which may be a 100pF capacitor, but this capacitor provides a block at DC. When the voltage goes high, diode 62 starts to conduct, takes current and puts charge onto the upper plate of the other capacitor 63. When the voltage goes low, the first diode 62 is reverse bias and the other diode 64 is forward biased. This restores charge to the first capacitor 61. Over time, the effect is to produce a DC output at 65.

An alternative implementation is shown in the example of Fig. 8, using a pair of rectifier circuits with a ¼ wavelength line 66. By tapping into the line 66 low down, the line resonates to increase the amplitude of the signal coming out to capacitor 61, so increasing the available voltage from the local oscillator, before rectifying the RF signal to generate the DC voltage. Due to parasitic capacitances 67, 68 of the diodes 64, 62, the required line is actually less than ¼ wavelength. The rectifier is tuned to 2.44GHz and the available voltage is further increased by adding two outputs 65 together, using another capacitor 69 in the middle line, effectively acting as new ground, to get twice the voltage out at the same current.

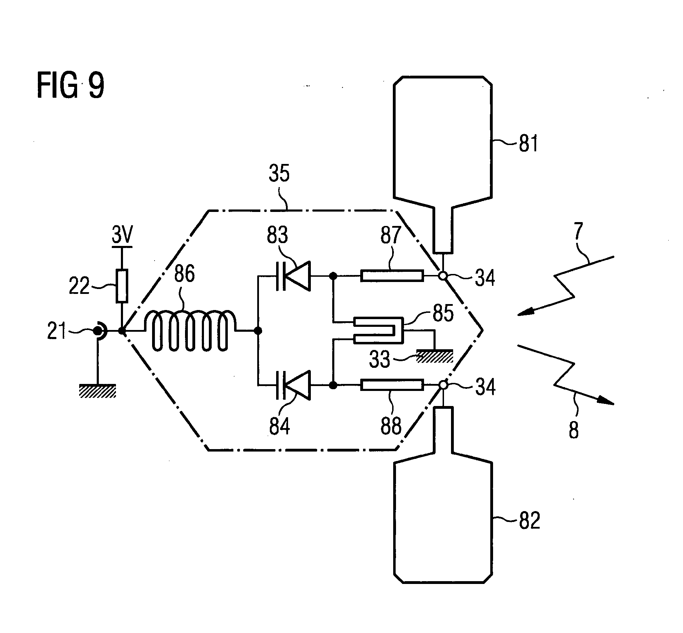

Fig.9 illustrates an alternative type of upconverter for use in the example of Fig.1. Instead of a mixer 23, a two-port parametric amplifier is used. The example of Fig. 9 comprises a parametric amplifier core 35 having a single ended input 21 to receive the input signal 13, together with an earth 20 at the input and an output port 34 for connection to a dipole antenna 81, 82. The input signal 13, typically at less than 250MHz, is fed via a high Q sub carrier frequency input inductor 23 to drive the varactor diode pair 83, 84 in common mode parallel with 'earth return' via the shunt matching line pair 85 to ground connection 33. A high impedance (very low current requirement) voltage source provides bias voltage 22 at e.g. 3 V via the high Q sub carrier frequency input matching choke 86 to the varactor diode pair 83, 84 (e.g. BBY53-02V) to set the correct operational capacitance bias point. Incident local oscillator 'pump' signal 7 (at a frequency for example of 2.44GHz) received by the microwave antenna 81, 82 is fed via the appropriate printed microwave series matching lines 87, 88 and shunt matching lines 85 to provide differential drive (with centre ground 33) to the varactor diode pair 83, 84. This differential LO signal 7 mixes with the common mode sub carrier frequency drive signal 13 in the varactor diodes 83, 84 to produce microwave frequency lower side band (LSB) and upper side band (USB) products. These differential mode mixing products are fed back through the microwave matching lines 87, 88 to the microwave antenna 81, 82 for transmission back to the bore array of transceivers.

The two varactor diodes 83, 84 of the parametric amplifier circuit serve as an upconverter and an amplifier that requires no DC power supply, using directly the 'pump' signal 7 as a local oscillator and source of power. Parametric amplifiers are typically two port devices where a first port receives an input signal at a relatively low frequency to be upconverted and amplified and a second port both receives the pump signal at a relatively high frequency and outputs the relatively high frequency upconverted and amplified mixing product.

For the example, the pump signal 7 to the parametric amplifier is received from an over-the-air transmission in order to remove any requirement for a DC power supply to the remote control device. The total bandwidth occupied by the upper and lower sidebands and the pump signal 7 is typically small enough to fall within the efficient bandwidth of a single antenna. Thus, a two port parametric amplifier circuit, is provided such that the first port 21 receives the input signal 13 to be upconverted and amplified and the second port 34 receives the pump signal 7 and also outputs the upconverted and amplified input signal 8 at the upper and lower sideband frequencies.

The local oscillator signal 7 received by the dipole antenna 81, 82 from the host transmitter 9 arrives at the microwave port 34 at a power level of, typically, +10dBm. This 'pump' signal is fed via the printed line matching 87, 88 to the varactor diode pair 83, 84. The common cathode configuration of the varactor diodes, with the anodes connected one to each half of the balanced feed from the dipole antenna 81, 82, results in antiphase stimulation of the varactor diodes at the LO (pump) frequency. Stimulation via the sub carrier frequency input inductor 86 at the common cathode node leads to in-phase stimulation of the varactor diodes 83, 84 at the input frequency. The resulting LSB and USB signals generated in each of the two varactor diodes are therefore in anti-phase. These wanted output signals, along with the greater (reflected) part of the incident LO signal 7, are then conveyed via the printed line matching 87, 88 back to the dipole antenna 81, 82 where the signals 8 are broadcast for reception by the host 9.

The high Q sub carrier frequency input matching choke 23 in series with the single ended sub carrier frequency input 21 is series resonant with the high capacitive reactance of the varactor diodes 83, 84at the sub carrier frequency frequency. The earth return for the sub carrier frequency feed 21 is provided by the centre grounding 33 of the microwave port shunt line. The centre-grounded shunt microstrip line in the microwave port resonates with the greater part of the high capacitive admittance of the varactor diodes 83, 84 at the microwave port frequency. The balanced pair of series lines 87, 88 then tunes out the remainder of the capacitive reactance of the varactor diodes and completes the impedance transformation to match to the 22Ω balanced load of the microwave dipole antenna 81, 82.

In this implementation, the diodes are connected in parallel for the sub carrier frequency feed, to halve the high impedance of the varactor diodes at the sub-carrier frequency for presentation at the input port. The diodes are connected in series for the microwave port 34 to double the very low impedance of the varactor diodes at 2.442GHz for presentation at the microwave port. The series / parallel configuration lends itself to single ended drive, balanced microwave drive and two port operation. A single ended drive of the parameteric amplifier is appropriate at likely sub-carrier frequencies and is effected by means of drive through the sub carrier frequency input choke 86 and ground return 33 at the microwave port voltage node. A balanced microwave port is appropriate at typically 2.5GHz for connection to a dipole antenna.

The microwave port operates fully balanced for LO "pump" feed, typically at 2.5GHz, as well as for the output frequencies at 2.5GHz ± sub-carrier frequency. The sub carrier frequency may vary depending on the device, e.g. keyboard, mouse, remote control, game controller, etc. This obviates the need for any low impedance grounding in the microwave port circuits. Operation of the microwave port fully balanced suits perfectly connection to the balanced dipole antenna 81, 82 for reception of the LO signal 7 and re-radiation of the LSB and USB signals 8.

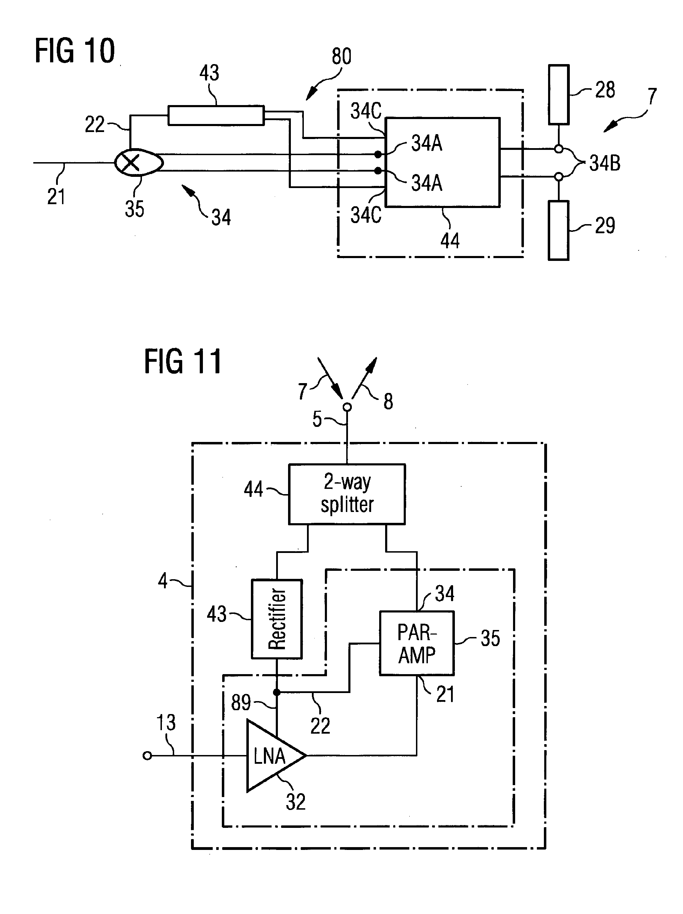

Power harvesting for the parametric amplifier embodiment works in a similar way as has been described for the mixer. DC power is harvested from the local oscillator signal 7 to provide the necessary power 89 for the LNA 32 and DC bias voltage 22 for the parametric amplifier 35. As shown in Fig. 10, using a power splitter 44, the local oscillator received at port 34B is split between ports 34A for the microwave port 24 and ports 34C for the rectifier 43, allowing one part of the incident LO signal to connect to the microwave frequency port 34, which channels local oscillator power and returns upconverted side bands and another part of the signal from the power splitter 44 to connect to the power harvesting circuit 43 as described hereinbefore.

An input signal 13 input to the upconverter 4 is amplified in the low noise amplifier (LNA) 32 and input to the input port 21 of the two port parametric amplifier 35. A radiated local oscillator (LO) signal 7 from the microwave antenna 3 in the host 9 is received at the microwave antenna 5 connected to the microwave frequency port 34 of the parametric amplifier. The input signal 13 and LO signal 7 produce upper and lower sidebands, still within the bandwidth of the host antenna 3 and one, other, or both of the sidebands are radiated for reception by receivers in the host 9 which then process the signals 8.

In one example, the remote control device may be one of a wireless computer keyboard and a wireless mouse. The present invention enables wireless communication via a microwave link between a host computer and remote ancillaries to be implemented without the use of batteries. The host computer communicates wirelessly to the remote keyboard and mouse without the need for an additional power source in the keyboard or mouse itself. A low power microwave signal is transmitted from the host computer and is received by the remote control device, then used to generate local power via the use of the mixer or parametric amplifier as described above. The invention enables the devices to be much smaller and lighter than currently, as there is no need for a battery pack and the power harvesting upconverter circuitry may be implemented on an integrated circuit, so taking up only a small amount of space. In use, there is no need to replace batteries, so leading to a more environmentally friendly product, as well as avoiding the frustrations of actually finding and replacing batteries. Information from the remote device can be transmitted back to the host (e.g. mouse click or keyboard strokes) using the same mechanism.

In another example, a wireless remote control system for a television receiver using the device and techniques described above. The remote control can communicate wirelessly to the host, which is a consumer electronics device, such as a TV, DVD or HiFi, without the need for an additional power source within the remote control. The desired channel to change to, volume, or other similar information from the remote control is transmitted back to the host. Another application for use with such consumer electronics is a wireless electronic games controller unit which can communicate wirelessly to the host.

## Claims

1. A wireless control device (1), the device comprising an antenna (5) and a power harvester (2) to generate power for the device from a radio frequency signal (7) incident on the antenna (5); the device (1) further comprising a power splitter (44) to split the incident signal (7); and an upconverter stage; the upconverter stage comprising one of a low noise amplifier (20) and a two port mixer (23), or a two port parametric amplifier (35); the two ports comprising a first port (21) to receive a control signal (13) to be upconverted and a second port (34) to receive the incident radio frequency signal (7) and to output the upconverted control signal (8) at upper and lower sideband frequencies; wherein the antenna (5) is coupled to the second port (34).

2. A device according to claim 1, wherein when the upconverter stage comprises a two port parametric amplifier, a low noise amplifier (32) is provided at the first port (21) of the parametric amplifier.

3. A device according to claim 1 or claim 2, wherein when the upconverter stage comprises a two port parametric amplifier, the two port parametric amplifier (35) comprises a pair of varactor diodes (28, 29) connected between the first port (21) and the second port (34); wherein the diodes are connected in parallel from the first port (21) and in series from the second port (34); wherein the first port (21) receives an input signal via the low noise amplifier (32); and wherein the second port (34) receives an incident local oscillator signal (7) and outputs an upconverted amplified input signal (8).

4. A device according to claim 2, wherein the power harvester (2) provides a DC voltage supply (89) to the low noise amplifier (32).

5. A device according to any preceding claim, wherein the power harvester (2) includes a Cockcroft Walton multiplier.

6. A device according to any preceding claim, wherein the power harvester (2) includes an impedance circuit to increase the available RF voltage from the local oscillator prior to rectification to DC.

7. A device according to any preceding claim, wherein when the upconverter stage comprises a low noise amplifier (20) and a two port mixer (23), the power splitter (44) is coupled between the second port (34) of the mixer and the antenna (5).

8. A device according to claim 7, wherein the power splitter (44) splits incident local oscillator power between two outputs (34A, 34C), one output being connected to the power harvester (2) and the other output being connected to the second port (34) of the upconverter stage.

9. A device according to claim 7 or claim 8, wherein the power splitter (44) comprises one of a directional coupler and a Wilkinson coupler.

10. A device according to any preceding claim, wherein the second port (34) receives signals in the frequency range 2GHz to 3 GHz.

11. A device according to any preceding claim, wherein the wireless control device (1) is one of a games console remote control, a personal entertainment remote control, a keyboard, or a mouse.

12. A wireless system comprising a device according to any preceding claim and a host, the host (9) further comprising a signal generator to generate the radio frequency signal (7) and an antenna (3) from which to transmit the radio frequency signal.

## Patentansprüche

1. Drahtlose Steuervorrichtung (1), wobei die Vorrichtung eine Antenne (5) und eine Energiegewinnungseinrichtung (2) zum Erzeugen von Energie für die Vorrichtung aus einem auf die Antenne (5) einfallenden Hochfrequenzsignal (7) umfasst; wobei die Vorrichtung (1) ferner einen Leistungsteiler (44) zum Teilen des einfallenden Signals (7) und eine Aufwärtswandlerstufe umfasst; wobei die Aufwärtswandlerstufe entweder einen rauscharmen Verstärker (20) und einen Mischer (23) mit zwei Anschlüssen umfasst, oder einen parametrischen Verstärker (35) mit zwei Anschlüssen; wobei die zwei Anschlüsse einen ersten Anschluss (21) zum Empfangen eines Steuersignals (13), das einer Aufwärtswandlung unterzogen werden soll, und einen zweiten Anschluss (34) zum Empfangen des einfallenden Hochfrequenzsignals (7) und zum Ausgeben des aufwärts gewandelten Steuersignals (8) mit oberer und unterer Seitenbandfrequenz umfassen; wobei die Antenne (5) mit dem zweiten Anschluss (34) gekoppelt ist.

2. Vorrichtung nach Anspruch 1, wobei, wenn die Aufwärtswandlerstufe einen parametrischen Verstärker mit zwei Anschlüssen umfasst, ein rauscharmer Verstärker (32) an dem ersten Anschluss (21) des parametrischen Verstärkers vorgesehen ist.

3. Vorrichtung nach Anspruch 1 oder Anspruch 2, wobei, wenn die Aufwärtswandlerstufe einen parametrischen Verstärker mit zwei Anschlüssen umfasst, der parametrische Verstärker mit zwei Anschlüssen (35) ein Paar Varaktordioden (28, 29) umfasst, das zwischen den ersten Anschluss (21) und den zweiten Anschluss (34) geschaltet ist; wobei die Dioden parallel zu dem ersten Anschluss (21) und in Reihe zu dem zweiten Anschluss (34) geschaltet sind; wobei der erste Anschluss (21) ein Eingangssignal über den rauscharmen Verstärker (32) empfängt; und wobei der zweite Anschluss (34) ein einfallendes lokales Oszillatorsignal (7) empfängt und ein aufwärts gewandeltes verstärktes Eingangssignal (8) ausgibt.

4. Vorrichtung nach Anspruch 2, wobei die Energiegewinnungseinrichtung (2) dem rauscharmen Verstärker (32) eine DC-Versorgungsspannung (89) zuführt.

5. Vorrichtung nach einem der vorhergehenden Ansprüche, wobei die Energiegewinnungseinrichtung (2) einen Cockcroft-Walton-Generator aufweist.

6. Vorrichtung nach einem der vorhergehenden Ansprüche, wobei die Energiegewinnungseinrichtung (2) eine Impedanzschaltung aufweist, um die verfügbare HF-Spannung von dem lokalen Oszillator vor der Gleichrichtung zu DC zu erhöhen.

7. Vorrichtung nach einem der vorhergehenden Ansprüche, wobei, wenn die Aufwärtswandlerstufe einen rauscharmen Verstärker (20) und einen Mischer (23) mit zwei Anschlüssen umfasst, der Leistungsteiler (44) zwischen den zweiten Anschluss (34) des Mischers und die Antenne (5) gekoppelt ist.

8. Vorrichtung nach Anspruch 7, wobei der Leistungsteiler (44) einfallende Leistung eines lokalen Oszillators zwischen zwei Ausgängen (34A, 34C) aufteilt, wobei ein Ausgang mit der Energiegewinnungseinrichtung (2) verbunden ist und der andere Ausgang mit dem zweiten Anschluss (34) der Aufwärtswandlerstufe verbunden ist.

9. Vorrichtung nach Anspruch 7 oder Anspruch 8, wobei der Leistungsteiler (44) entweder einen Richtungskoppler oder einen Wilkinson-Koppler umfasst.

10. Vorrichtung nach einem der vorhergehenden Ansprüche, wobei der zweite Anschluss (34) Signale in dem Frequenzbereich von 2 GHz bis 3 GHz empfängt.

11. Vorrichtung nach einem der vorhergehenden Ansprüche, wobei die drahtlose Steuervorrichtung (1) entweder eine Spielkonsolen-Fernbedienung oder eine Fernbedienung eines Gerätes der Unterhaltungselektronik oder eine Tastatur oder eine Maus ist.

12. Drahtloses System, welches eine Vorrichtung nach einem der vorhergehenden Ansprüche und einen Host umfasst, wobei der Host (9) ferner einen Signalgenerator zum Erzeugen des Hochfrequenzsignals (7) und eine Antenne (3), von welcher das Hochfrequenzsignal gesendet werden soll, umfasst.

## Revendications

1. Dispositif de commande sans fil (1), le dispositif comprenant une antenne (5) et un collecteur d'énergie (2) servant à produire de l'énergie pour le dispositif à partir d'un signal radioélectrique (7) incident reçu par l'antenne (5), le dispositif (1) comprenant par ailleurs un diviseur de puissance (44) servant à diviser le signal (7) incident et un étage élévateur de fréquence, l'étage élévateur de fréquence comprenant un amplificateur à faible bruit (20) et un mélangeur (23) à deux ports ou un amplificateur paramétrique (35) à deux ports, les deux ports comprenant un premier port (21) servant à recevoir un signal de commande (13) à élever en fréquence et un second port (34) servant à recevoir le signal radioélectrique (7) incident et à sortir le signal de commande (8) élevé à des fréquences de bande latérale supérieure et inférieure, étant entendu que l'antenne (5) est couplée au second port (34).

2. Dispositif selon la revendication 1, dans lequel, lorsque l'étage élévateur de fréquence comprend un amplificateur paramétrique à deux ports, un amplificateur à faible bruit (32) est prévu au niveau du premier port (21) de l'amplificateur paramétrique.

3. Dispositif selon la revendication 1 ou la revendication 2, dans lequel, lorsque l'étage élévateur de fréquence comprend un amplificateur paramétrique à deux ports, l'amplificateur paramétrique (35) à deux ports comprend une paire de diodes varicaps (28, 29) montées entre le premier port (21) et le second port (34), étant entendu que les diodes sont montées en parallèle depuis le premier port (21) et en série depuis le second port (34), que le premier port (21) reçoit un signal d'entrée par le biais de l'amplificateur à faible bruit (32) et que le second port (34) reçoit un signal incident (7) d'oscillateur local et sort un signal d'entrée amplifié (8) élevé en fréquence.

4. Dispositif selon la revendication 2, dans lequel le collecteur d'énergie (2) fournit une alimentation en tension continue (89) à l'amplificateur à faible bruit (32).

5. Dispositif selon l'une quelconque des revendications précédentes, dans lequel le collecteur de puissance (2) comprend un multiplicateur de Cockcroft-Walton.

6. Dispositif selon l'une quelconque des revendications précédentes, dans lequel le collecteur d'énergie (2) comprend un circuit d'impédance pour accroître la tension à haute fréquence disponible à partir de l'oscillateur local avant le redressement en courant continu.

7. Dispositif selon l'une quelconque des revendications précédentes, dans lequel l'étage élévateur de fréquence comprend un amplificateur à faible bruit (20) et un mélangeur (23) à deux ports, le diviseur de puissance (44) étant monté entre le second port (34) du mélangeur et l'antenne (5).

8. Dispositif selon la revendication 7, dans lequel le diviseur de puissance (44) répartit la puissance incidente de l'oscillateur local entre deux sorties (34A, 34C), une sortie étant reliée au collecteur de puissance (2) et l'autre sortie étant reliée au second port (34) de l'étage élévateur de fréquence.

9. Dispositif selon la revendication 7 ou la revendication 8, dans lequel le diviseur de puissance (44) comprend un coupleur directif ou un coupleur de Wilkinson.

10. Dispositif selon l'une quelconque des revendications précédentes, dans lequel le second port (34) reçoit des signaux dans la gamme de fréquences allant de 2 GHz à 3 GHz.

11. Dispositif selon l'une quelconque des revendications précédentes, dans lequel le dispositif de commande sans fil (1) est une télécommande de console de jeux, une télécommande de dispositif de divertissement personnel, un clavier ou une souris.

12. Système sans fil comprenant un dispositif selon l'une quelconque des revendications précédentes et un hôte, l'hôte (9) comprenant par ailleurs un générateur de signaux pour produire le signal radioélectrique (7) et une antenne (3) à partir de laquelle émettre le signal radioélectrique.
